# EUROPÄISCHE PATENTSCHRIFT

(11) **EP 2 880 455 B1**
(45) Veröffentlichungstag und Bekanntmachung des Hinweises auf die Patenterteilung: **26.05.2021**
(21) Anmeldenummer: 13740208.7
(22) Anmeldetag: 15.07.2013
(51) Int. Cl.: G01R 31/26

(54) **UNTERSUCHUNGSVORRICHTUNG UND -VERFAHREN ZUR ERFASSUNG VON EIGENSCHAFTEN EINES MATERIALS IN EINER BAUELEMENT-PROBE**
INSPECTION APPARATUS AND METHOD FOR DETECTING PROPERTIES OF A MATERIAL IN A COMPONENT SAMPLE
DISPOSITIF ET PROCÉDÉ D'ANALYSE POUR DÉTERMINER DES PROPRIÉTÉS D'UN MATÉRIAU CONTENU DANS UN ÉCHANTILLON D'ÉLÉMENT DE CONSTRUCTION

(30) Priorität: 03.08.2012 DE 102012015505
(43) Veröffentlichungstag der Anmeldung: 10.06.2015
(73) Patentinhaber: Fluxim AG, 8835 Feusisberg (CH)
(72) Erfinder: NITSCHE, Robert, 01328 Dresden (DE); BERKEL, Werner, 71263 Weil der Stadt (DE)
(74) Vertreter: Kailuweit & Uhlemann Patentanwälte Partnerschaft mbB
(86) Internationale Anmeldenummer: PCT/EP2013/002097
(87) Internationale Veröffentlichungsnummer: WO 2014/019643

(56) Entgegenhaltungen:
- EP-B1- 2 132 581
- US-A- 5 508 632
- US-A- 6 073 082
- US-A1- 2002 116 691
- US-A1- 2012 187 975

## Beschreibung

Die Erfindung betrifft eine Untersuchungsvorrichtung zur Erfassung von Eigenschaften mindestens eines Materials, das in einer Bauelement-Probe enthalten ist, insbesondere eine Untersuchungsvorrichtung zur Erfassung von Eigenschaften von Materialien elektronischer Bauelemente, wie z. B. organischer Leuchtdioden, auf der Grundlage mindestens einer elektrischen Messung an der Bauelement-Probe. Die Erfindung betrifft des Weiteren ein Verfahren zur Erfassung von Eigenschaften eines Materials, das in einer Bauelement-Probe enthalten ist, insbesondere ein Untersuchungsverfahren zur Erfassung von Eigenschaften Materialien elektronischer Bauelemente, wobei das Verfahren mindestens eine elektrische Messung an der Bauelement-Probe enthält. Anwendungen der Erfindung sind insbesondere bei der Charakterisierung von Materialien elektronischer Bauelemente, insbesondere von opto-elektronischen Bauelementen gegeben. Die Erfindung ist insbesondere für eine Charakterisierung von organischen Materialien, anorganischen Materialien oder zusammengesetzten Materialien mit organischen und anorganischen Bestandteilen geeignet.

Die Herstellung elektronischer Bauelemente auf der Grundlage organischer Materialien (organische Bauelemente) ist allgemein bekannt. Organische Bauelemente haben elektrische Eigenschaften, die sich aufgrund von Unterschieden der Generation und der Bewegung elektrischer Ladungsträger deutlich von denen anorganischer Halbleiter unterscheiden. Bisher zeichnen sich organische Bauelemente insbesondere durch eine geringe elektrische Leitfähigkeit und eine geringe Ladungsträgerbeweglichkeit aus, so dass sie für die klassischen Anwendungen anorganischer Halbleiter, z. B. in der Rechentechnik oder der Schaltelektronik, nur beschränkt geeignet sind. Dennoch besteht ein starkes Interesse an organischen Bauelementen, da diese relativ einfach herstellbar und aufgrund der Wechselwirkung der meisten interessierenden organischen Materialien mit Licht zahlreiche optisch-elektrische Anwendungen haben. Es ist beispielsweise allgemein bekannt, organische Leuchtdioden oder auch photovoltaische Bauelemente (Solarzellen) aus organischen Materialien herzustellen.

Aufgrund der Komplexität organischer Moleküle und der empfindlichen Abhängigkeit elektrischer Eigenschaften eines organischen Materials von dessen konkreter Beschaffenheit in einem organischen Bauelement besteht ein Interesse, die Eigenschaften von organischer Materialien, wie z. B. die Ladungsträgerbeweglichkeit oder die elektrisch wirksamen Fallenzustände (Störstellen bzw. so genannte "Traps"), möglichst genau zu charakterisieren. Hierzu ist zur Charakterisierung organischer Materialien, die z. B. zur Herstellung organischer Leuchtdioden (OLED's) verwendet werden, bekannt, Materialeigenschaften beispielsweise wie folgt zu erfassen. An der Probe des organischen Materials, z. B. in Schichtform, wird eine elektrische Messung durchgeführt, z. B. eine Strom-Spannungs-Kennlinie (I-U-Kennlinie) gemessen. Anschließend wird eine Modell-basierte, numerische Simulationsfunktion, welche die interessierenden Materialeigenschaften der Probe, wie z. B. die Ladungsträgerbeweglichkeit, als Parameter enthält, an die Ergebnisse der elektrischen Messung angepasst. Aus der angepassten Simulationsfunktion werden dann unmittelbar die Materialeigenschaften ermittelt. EP 2 132 581 B1 offenbart ein solches Verfahren zum Bestimmen des Status und/oder Zustands einer LED/OLED-Einheit.

Eine in der Praxis verwendete Technik, bei der Eigenschaften organischer Materialien wie beschrieben aus einer elektrischen Messung und einer Anpassung einer Simulationsfunktion an die Ergebnisse der elektrischen Messung erfasst werden, ist beispielsweise unter der Bezeichnung "SimOLED FITTING" (Hersteller: sim4tec GmbH, Deutschland) oder Messplattform "Paios" und Simulationssoftware "Setfos" (Hersteller: Fluxim AG, Schweiz) kommerziell verfügbar. Bei der Anwendung dieser herkömmlichen Technik hat es sich als nachteilig erwiesen, dass die gewünschten Eigenschaften der organischen Proben häufig nur dann mit einer ausreichenden Reproduzierbarkeit ermittelt werden können, wenn die elektrische Messung von einem erfahrenen Anwender durchgeführt und bewertet wird. Die herkömmliche Technik liefert zwar ein Hilfsmittel beim Entwurf organischer Bauelemente, wobei dessen Anwendung jedoch zusätzlich Erfahrungen bei der Durchführung und Bewertung der elektrischen Messung erfordert.

Bei der Charakterisierung organischer Materialien ist insbesondere die Lage der Energieniveaus, z. B. das höchste besetzte Molekülorbital (highest occupied molecular orbital, HOMO) und/oder das niedrigste unbesetzte Molekülorbital (lowest unoccupied molecular orbital, LUMO) im Feststoffmaterial von Interesse. Bisher sind lediglich für HOMO-Messungen physikalische oder chemische Verfahren verfügbar, deren Durchführung aufwändig ist und teure Geräte erfordert. So wird als physikalisches Verfahren für HOMO-Messungen an festen Schichten organischer Materialien standardmäßig eine UPS-Messung (Ultraviolet Photon Spectroscopy) verwendet. Diese Methode ist wegen der erforderlichen Präparation der Probe und Messung im Vakuum umständlich und sehr teuer. Als chemisches Verfahren für HOMO- und LUMO-Messungen wird das Verfahren Cyclovoltammetrie verwendet. Dieses Verfahren hat jedoch eine Reihe von Nachteilen. Die organischen Moleküle werden in Lösung und nicht als feste Schicht gemessen, wobei eine empfindliche Abhängigkeit des Messergebnisses von der Qualität der Referenzelektroden und des Lösungsmittels besteht. Generell ist auch dieses Verfahren aufwändig und teuer.

Auch Verunreinigungskonzentrationen wurden bisher mit chemischen Verfahren gemessen, die jedoch eine beschränkte Genauigkeit und insbesondere eine ungenügende Auflösung haben, um den Einfluss von Verunreinigungen auf elektrische Eigenschaften zu bestimmen. Mit den chemischen Verfahren werden alle Verunreinigungen unabhängig von der Tatsache erfasst, ob diese elektrisch relevant sind oder nicht.

Die genannten Probleme treten nicht nur bei der Charakterisierung von organischen Materialien mit den genannten Verfahren, sondern auch bei der Charakterisierung von anorganischen Materialien, z. B. Metallen oder Oxiden, oder zusammengesetzten, organischen und anorganischen Materialien mit an diese angepassten Untersuchungsverfahren auf.

Die Aufgabe der Erfindung ist es, eine verbesserte Untersuchungsvorrichtung zur Erfassung der Eigenschaften von Materialien, insbesondere zur Anwendung in elektronischen Bauelementen, bereitzustellen, mit der Nachteile herkömmlicher Techniken überwunden werden. Die Untersuchungsvorrichtung soll insbesondere ermöglichen, die Materialeigenschaften mit einer erhöhten Zuverlässigkeit und/oder Reproduzierbarkeit zu erfassen und/oder für erweiterte Anwendungen geeignet sein. Des Weiteren ist es eine Aufgabe der Erfindung, ein verbessertes Untersuchungsverfahren zur Erfassung von Eigenschaften von Materialien bereitzustellen, mit dem Nachteile herkömmlicher Techniken vermieden werden und das insbesondere mit erhöhter Zuverlässigkeit und/oder Reproduzierbarkeit ausführbar und/oder für erweiterte Anwendungen geeignet ist. Die Erfindung soll insbesondere eine Automatisierung der Erfassung der Materialeigenschaften ermöglichen.

Diese Aufgaben werden durch eine Untersuchungsvorrichtung und ein Untersuchungsverfahren jeweils mit den Merkmalen der unabhängigen Ansprüche gelöst. Vorteilhafte Ausführungsformen und Anwendungen der Erfindung ergeben sich aus den abhängigen Ansprüchen.

Gemäß einem ersten allgemeinen Gesichtspunkt der Erfindung wird eine Untersuchungsvorrichtung bereitgestellt, die zur Erfassung von Eigenschaften eines Materials konfiguriert ist, das in einer Bauelement-Probe enthalten ist, und die eine Messeinrichtung, eine Simulations- und Auswerteeinrichtung und eine Ausgabeeinrichtung umfasst. Die Messeinrichtung ist für elektrische Messungen an der Bauelement-Probe ausgelegt und umfasst mindestens zwei elektrische Anschlüsse, über die elektrische Messwerte, wie z. B. Spannungen und/oder Ströme und/oder davon abgeleitete Größen, an der Bauelement-Probe erfassbar sind. Die Simulations- und Auswerteeinrichtung ist zur Anpassung einer Simulationsfunktion, welche mindestens eine der gesuchten Eigenschaften als veränderlichen Parameter enthält, an die elektrischen Messwerte der Messeinrichtung konfiguriert. Die Simulations- und Auswerteeinrichtung umfasst z. B. einen Rechnerschaltkreis, auf dem ein Simulationsprogramm läuft, oder einen Simulations-Schaltkreis, der Hardware-basiert für die Anpassung der Simulationsfunktion ausgelegt ist. Die Ausgabeeinrichtung ist ein Teil der Simulations- und Auswerteeinrichtung oder mit dieser verbunden und geeignet, die gesuchten Eigenschaften des organischen Materials aus der angepassten Simulationsfunktion, insbesondere den betreffenden Parametern der angepassten Simulationsfunktion auszugeben.

Erfindungsgemäß umfasst die Untersuchungsvorrichtung eine Steuereinrichtung, die zur Steuerung der Messeinrichtung und/oder der Simulations- und Auswerteeinrichtung angepasst ist. Die Steuereinrichtung ist zur Speicherung einer materialspezifischen Steuerfunktion angepasst. In Abhängigkeit von der Steuerfunktion wird die Messeinrichtung auf ein bestimmtes Messprogramm und/oder zur Durchführung mindestens einer elektrischen Messung mit bestimmten Messbedingungen eingestellt. Alternativ oder zusätzlich wird in Abhängigkeit von der Steuerfunktion die Simulations- und Auswerteeinrichtung zur Anwendung einer bestimmten Simulationsfunktion eingestellt. Die mindestens eine elektrische Messung umfasst z. B. eine Strom-Spannungs-Messung und/oder eine Impedanzspektroskopie-Messung (Messung der Impedanz und insbesondere der Kapazität vs. Frequenz) und/oder eine CV-Spektroskopie-Messung (Messung der Kapazität vs. Spannung). Die Steuerung der Messeinrichtung und/oder der Simulations- und Auswerteeinrichtung erfolgt in Abhängigkeit von vorbekannten Eigenschaften der Bauelement-Probe, die z. B. vorbekannte Eigenschaften des Probenaufbaus (z. B. Zahl der Schichten, laterale Schichtausdehnung und/oder Schichtdicken), physikalisch-chemische Eigenschaften (z. B. chemische Zusammensetzung, physikalische Funktion) und/oder geometrische Eigenschaften (Probenbeschaffenheit, Ort der Kontaktierung und dergleichen) der Probe umfassen.

Die Steuerfunktion enthält Vorschriften, welche Bauelement-Probe mit welchem Messprogramm und/oder unter welchen Bedingungen vermessen wird. Die Erfinder haben festgestellt, dass durch die Steuerung der Messeinrichtung und/oder der Simulations- und Auswerteeinrichtung mit der Steuerfunktion, d. h. insbesondere durch die Vorgabe von Messprogrammen und/oder Messbedingungen die Nachteile herkömmlicher Techniken minimiert oder überwunden werden können. Während herkömmliche Messungen stark von den Erfahrungen und dem Geschick des Nutzers abhängen können und damit ggf. nur beschränkt vergleichbare und reproduzierbare Ergebnisse liefern sowie in ihrer Anwendung oft auf Laboruntersuchungen beschränkt sind, ermöglicht die Erfindung eine Automatisierung der Charakterisierung von Eigenschaften organischer Materialien für organische opto-elektronische Bauelemente. Die Erfindung eröffnet eine neue Anwendung der an sich bekannten Verfahren zur Erfassung von Eigenschaften organischer, anorganischer oder zusammengesetzter Materialien auf der Grundlage von Simulationen im Bereich automatisch arbeitender Anlagen, insbesondere im realen Produktionsprozess. Die Erfindung ermöglicht vorteilhafterweise eine Automatisierung der Messungen. Im Vergleich zu herkömmlichen Techniken ergibt sich ein erheblich geringerer Aufwand bei gleichzeitiger Möglichkeit, mehrere Parameter innerhalb eines Prozesses zu gewinnen.

Ein wichtiger weiterer Vorteil der Erfindung ist es, dass die Untersuchungsvorrichtung geeignet ist, mehrere verschiedene Materialeigenschaften zu erfassen. Die beschränkende Spezialisierung herkömmlicher Techniken auf die Messung bestimmter einzelner Materialeigenschaften wird überwunden. Beispielsweise können erfindungsgemäß sowohl Energieniveaus in einem organischen Material, insbesondere das höchste besetzte Molekülorbital (highest occupied molecular orbital, HOMO) und/oder das niedrigste unbesetzte Molekülorbital (lowest unoccupied molecular orbital, LUMO) und die Energiedifferenz zwischen HOMO und LUMO, als auch die Beweglichkeit von Ladungsträgern im organischen Material als auch die Konzentration elektrisch wirksamer Fallenzustände, insbesondere die Konzentration von elektronisch wirksamen Verunreinigungen, Störstellen und/oder Defekten erfasst werden. Gemäß einem weiteren Beispiel kann erfindungsgemäß an einem anorganischen Material eine Austrittsarbeit erfasst werden.

Ein besonderer Vorteil der Erfindung ist es, dass die Energieniveaus, die bisher lediglich mit physikalischen oder chemischen Verfahren festgestellt werden konnten, vereinfacht und mit hoher Zuverlässigkeit ermittelt werden können. Mit der Erfindung wird ein neuer und zuverlässiger Zugang zu den HOMO- und LUMO-Niveaus organischer Materialien geliefert. Die oben genannten Nachteile der herkömmlichen physikalischen oder chemischen Verfahren werden ausgeschlossen, weil die Untersuchung an Bauelement-Proben, insbesondere an Schichten oder Testbauelementen erfolgt, die dem finalen Bauelement sehr ähnlich sind.

Auch für die Ermittlung von Verunreinigungskonzentrationen ergeben sich Vorteile. Im Gegensatz zu den bekannten physikalischen oder chemischen Verfahren (z. B. HPLC, MS, TGA, DSC, AAS, licht-induzierte Störstellenemission, oder CV-Spektroskopie) werden mit der Erfindung mit vermindertem Aufwand ausschließlich die Konzentrationen der elektrisch relevanten Verunreinigungen gemessen, was für die Untersuchung der Probe für die Anwendung im organischen Bauelement von erheblichem Vorteil ist.

Vorzugsweise enthält die Probe mindestens eine Feststoffschicht, insbesondere eine organische, anorganische und/oder organisch-anorganisch zusammengesetzte Schicht zur Anwendung in einem elektronischen oder opto-elektronischen Bauelement. Eine organische Schicht ist z. B. eine Emitterschicht oder eine Absorberschicht aus mindestens einem organischen Farbstoff. Eine anorganische Schicht ist z. B. eine Elektrodenschicht aus einem Metall oder einer Metall-Legierung oder eine Passivierungsschicht aus einem Oxid. Eine organisch-anorganisch zusammengesetzte Schicht ist z. B. eine Polymerschicht, in die anorganische Partikel eingebettet sind. Besonders bevorzugt wird erfindungsgemäß eine organische Feststoffschicht untersucht, die aus einem organischen Material zur Anwendung in einer organischen Leuchtdiode, einem organischen Transistor, einer organischen Solarzelle, einem Schaltkreis, Sensoren und/oder Batterien vorgesehen ist. Die Anwendung der Erfindung ist jedoch nicht auf diese beispielhaft genannten organischen elektrischen Bauelemente beschränkt, sondern auch für Materialien anderer Bauelemente möglich. Besonders bevorzugt wird die Messung unmittelbar am organischen Bauelement ausgeführt. In diesem Fall ist die Probe Teil einer organischen Leuchtdiode, eines organischen Transistors und/oder einer organischen Solarzelle während deren Herstellung oder als fertiges Produkt.

Der Begriff "Bauelement-Probe" bezieht sich somit allgemein auf eine Probe, die als Schicht das Material, das charakterisiert werden soll, und die des Weiteren Teile eines elektronischen Bauelements, insbesondere ein Substrat, z. B. Glas oder Kunststoff, weitere Schichten organischer oder anorganischer Materialien und/oder Zuleitungen, z. B. aus Metall, Oxid, o. dgl. hergestellt, umfasst. Die Bauelement-Probe kann insbesondere wie ein halbfertiges oder fertiges Bauelement für die praktische Anwendung, z. B. wie eine OLED, aufgebaut sein. Vorteilhafterweise ermöglicht dies eine Anwendung der Erfindung insbesondere beim Prozess-Monitoring in einer Produktionslinie zur Herstellung elektronischer Bauelemente. An vorbestimmten Stellen in der Produktionslinie können, z. B. unmittelbar nach bestimmten Verfahrensschritten, wie Schichtabscheidung, Passivierung o. dgl., mit der Untersuchungsvorrichtung die Eigenschaften der Materialien gemessen werden und damit auf die Qualität des Verfahrensschrittes Rückschlüsse gezogen werden und ggf. Modifizierungen der Prozessführung durchgeführt werden.

Die Erfindung ist auf die Erfassung von Eigenschaften mindestens eines Materials der Probe gerichtet. Es können eine einzige Schicht, beispielsweise aus einem organischen Material, oder mehrere, z. B. aneinander grenzende Schichten aus gleichen oder verschiedenen Materialien in der Probe untersucht werden.

Gemäß einem zweiten allgemeinen Gesichtspunkt der Erfindung wird die oben genannte Aufgabe durch ein Verfahren zur Erfassung von Eigenschaften mindestens eines Materials einer Bauelement-Probe bereitgestellt, bei dem an der Bauelement-Probe elektrische Messwerte erfasst werden, eine Simulationsfunktion, welche die gesuchten Eigenschaften des organischen Materials als Parameter enthält, an die gemessenen elektrischen Messwerte angepasst wird und die gesuchten Eigenschaften aus der angepassten Simulationsfunktion ausgegeben werden. Gemäß dem erfindungsgemäßen Verfahren ist vorgesehen, dass mindestens einer der Schritte der Erfassung der elektrischen Messwerte und der Anpassung der Simulationsfunktion in Abhängigkeit von einer vorbestimmten, probenspezifischen Steuerfunktion gesteuert wird. Die Erfassung der elektrischen Messwerte erfolgt mit einer Messeinrichtung, während die Anpassung der Simulationsfunktion mit einer Simulations- und Auswerteeinrichtung erfolgt. Zur Ausgabe der Eigenschaften der untersuchten Probe ist eine Ausgabeeinrichtung vorgesehen, die optional als Teil der Simulations- und Auswerteeinrichtung gebildet sein kann.

Die erfindungsgemäße Steuerung der elektrischen Messung und/oder der Simulation erfolgt mit einer Steuereinrichtung. Die Mess-, Simulations- und Auswerte-, Ausgabe- und Steuereinrichtungen können zu einer Untersuchungsvorrichtung gemäß dem oben genannten ersten Gesichtspunkt der Erfindung zusammengefasst sein. Alternativ ist möglich, dass die genannten Komponenten voneinander zeitlich und/oder örtlich getrennt betrieben werden.

Ein wichtiger Vorteil der Erfindung besteht darin, dass die Beschränkungen herkömmlicher Techniken in Bezug auf die Zuverlässigkeit und Reproduzierbarkeit der ermittelten Probeneigenschaften überwunden und insbesondere eine Automatisierung der Probenuntersuchung ermöglicht werden. Damit ergeben sich erweiterte Anwendungen der simulationsbasierten Charakterisierung der zu untersuchenden Materialien sowohl im Labor als auch in der Produktion. Da die Untersuchung der Probe nahezu unabhängig vom Eingriff durch den Anwender gemacht werden kann, werden insbesondere im Produktionsprozess *in* situ-Messungen möglich, indem z. B. am Rand eines organischen Bauelements, wie z. B. einer OLED, Teststrukturen hergestellt und mit dem erfindungsgemäßen Verfahren untersucht werden.

Die Erfinder haben festgestellt, dass die Reproduzierbarkeit der Probenuntersuchung verbessert werden kann, wenn die Messung an mehreren (mindestens zwei) Bauelement-Proben mit verschiedener Geometrie, insbesondere mit verschiedenen Schichtdicken, erfolgt. Während herkömmliche Untersuchungen häufig auf die Messung z. B. organischer Schichten mit einer Dicke im um-Bereich beschränkt sind, die deutlich andere Eigenschaften als die praktisch interessierenden Schichten mit einer Dicke im nm-Bereich haben können, ermöglicht die Erfindung den Übergang zu einer Messung an schichtförmigen Proben, deren Materialeigenschaften so ähnlich wie möglich denen eines realen Bauelements sind. Besonders bevorzugt ist die Bauelement-Probe unter identischen Abscheide-/Prozessbedingungen wie das spätere Endprodukt hergestellt. Dazu im Gegensatz arbeiten alle herkömmlichen Verfahren mit separaten Proben mit Geometrien, die sich deutlich von denen eines realen Bauelements unterscheiden.

Vorteilhafterweise sind verschiedene Varianten der Einstellung der elektrischen Messung möglich, die gemäß bevorzugten Ausführungsformen der Erfindung einzeln oder in Kombination realisiert sein können. Gemäß einer ersten Variante kann vorgesehen sein, dass mit der gespeicherten Steuerfunktion elektrische Messbereiche der elektrischen Messung eingestellt werden. Beispielsweise wird für die Messung einer Strom-Spannungs-Kennlinie ein Spannungs-Bereich vorgegeben, in dem die Daten für die Kennlinie gemessen werden und für den die nachfolgende Simulation die optimalen Simulationsergebnisse liefert. Gemäß einer zweiten Variante können mit der gespeicherten Steuerfunktion geometrische Messbedingungen eingestellt werden. Geometrische Messbedingungen umfassen z. B. Messbedingungen in Bezug auf die Anzahl der vermessenen Bauelement-Probe (eine einzige oder mehrere Proben) und/oder die Schichtdicke der Schicht des zu charakterisierenden organischen Materials in der oder den Bauelement-Probe(n). Beispielsweise ist möglich, dass die Bauelement-Probe mit einer Vielzahl elektrischer Kontakte versehen ist, die in Abhängigkeit von den Vorgaben der Steuerfunktion für die elektrische Messung verwendet werden. Vorteilhafterweise wird dadurch ermöglicht, Kennlinien entlang verschiedener Messstrecken in der Probe aufzunehmen. Gemäß einer dritten Variante kann die Steuerfunktion des Weiteren angepasst sein, Umgebungsbedingungen der Probe während der Messung einzustellen. Beispielsweise können elektrische Messwerte in Abhängigkeit von der Probentemperatur gemessen werden. Gemäß einer vierten Variante kann ein Zeitprogramm der Messung vorgeben werden. Beispielsweise kann die Steuerfunktion festlegen, zeitabhängige Messungen auszuführen oder Messzeiten bestimmen.

Ein wichtiges Merkmal der Erfindung besteht darin, dass die elektrische Messung und/oder die Simulation in Abhängigkeit von der vorgegebenen Steuerfunktion kontrolliert werden. Die Steuerfunktion, die in der Praxis z. B. durch eine Software und/oder einen Programmablauf mit einer Reihe von Steuerbefehlen, z. B. in Gestalt einer Textdatei, realisiert ist, wird in der Steuereinrichtung, die optional Teil der Messeinrichtung sein kann, gespeichert. Es ist allerdings nicht zwingend erforderlich, dass die Steuerfunktion unveränderlich ist. Gemäß einer vorteilhaften Variante der Erfindung kann vielmehr vorgesehen sein, dass die Steuerfunktion benutzerdefiniert verändert wird. Der Anwender kann die Steuerfunktion an die konkreten Anwendungsbedingungen und die von ihm gewünschten Messungen anpassen. Hierzu können die Messund/oder Steuereinrichtungen mit einer Eingabeschnittstelle versehen sein, um die Steuerfunktion zu speichern und/oder zu verändern.

Gemäß einer weiteren vorteilhaften Ausführungsform der Erfindung kann die Untersuchungsvorrichtung mit einer Filtereinrichtung ausgestattet sein, die für eine Auswahl von Nutzdaten aus mindestens einem Datensatz der elektrischen Messwerte als Eingangsgrößen für die Simulations- und Auswerteeinrichtung angepasst ist. Das erfindungsgemäße Verfahren zeichnet sich bei dieser Ausführungsform durch den Teilschritt einer Auswahl einer Gruppe von Nutzdaten aus den elektrischen Messwerten aus. Aus den gemessenen Daten werden die Daten herausgefiltert, die für die Simulation, insbesondere die Anpassung der Simulationsfunktion verwendet werden können. Hierzu enthält die Filtereinrichtung vorzugsweise algorithmisierte Regeln, z. B. zur Erkennung von Kriechströmen oder Strom begrenzenden parasitären Effekten oder von Inkonsistenzen in der Schichtdickenabhängigkeit von Messergebnissen. Die Filtereinrichtung bietet den besonderen Vorteil, dass nicht nur eine Aufbereitung der Messwerte für die Simulation erfolgt, sondern auch der Rechenaufwand der Simulation verringert wird. Das Untersuchungsergebnis kann mit erhöhter Geschwindigkeit bereitgestellt werden. Besonders bevorzugt ist eine Variante der Erfindung, bei der die Filtereinrichtung in Abhängigkeit von der gespeicherten Steuerfunktion steuerbar ist. Die Steuerfunktion enthält Steuerbefehle, welche die Auswahl der gewünschten Nutzdaten vorgeben.

Vorteilhafterweise kann die Filtereinrichtung für mindestens eine der folgenden Funktionen konfiguriert sein. Gemäß einer ersten Variante ist möglich, dass mit der Filtereinrichtung aus den elektrischen Messwerten fehlerhafte Messwerte herausgefiltert werden. Des Weiteren ist möglich, fehlerhafte Messwerte einer Anpassung des mindestens einen Datensatzes für die folgende Verarbeitung zu unterziehen, z. B. wenn sich aus der Konsistenzprüfung die Ursache eines Messfehlers und mittels physikalischer Modelle eine begründete Anpassung des Datensatzes ableiten lässt. Die Anpassung umfasst z. B. die Addition einer Offsetgröße von den Messwerten eines Datensatzes. Des Weiteren ist es möglich, eine optimierte Anzahl der Nutzdaten einzustellen. So ist es beispielsweise möglich, bei Kennlinien mit geringen Messwertschwankungen weniger Nutzdaten für die Simulation auszuwählen als bei gemessenen Kennlinien mit stark schwankenden Messwerten. Des Weiteren besteht die Möglichkeit, mit der Filtereinrichtung die Nutzdaten einer Wichtung zu unterziehen.

Vorteilhafterweise ist die Umsetzung der Erfindung nicht auf ein bestimmtes Messverfahren beschränkt, sondern vielmehr mit verschiedenen elektrischen Messungen möglich, die einzeln oder in Kombination angewendet werden können. Besonders bevorzugt ist eine elektrische Messung vorgesehen, bei der ein elektrischer Strom durch das zu untersuchende Material in Abhängigkeit von einer angelegten Spannung gemessen wird (Strom-Spannungs-Kennlinie, I-V). In diesem Fall ergeben sich Vorteile aus der Tatsache, dass zahlreiche, materialspezifische Simulationsfunktionen für Strom-Spannungs-Kennlinien verfügbar sind. Weiterhin kann z. B. alternativ oder ergänzend die elektrische Impedanz (Wechselstromimpedanz) in Abhängigkeit von der einer Bias-Spannung und der Frequenz gemessen werden (z. B. Kapazitäts-Spannungs-Kennlinie, C-V-f). Die Bias-Spannung kann in an sich bekannter Weise z. B. eine DC-Spannung sein, die ggf. mit einer AC-Spannung überlagert ist. Vorteilhafterweise ermöglicht diese Messung die Anwendung von Simulationsfunktionen, welche dynamische elektrische Eigenschaften des untersuchten Materials, wie z. B. Ladungsträgerbeweglichkeiten, enthalten.

Gemäß einer besonders bevorzugten Variante der Erfindung ist die Messeinrichtung sowohl für eine I-V- als auch für eine C-V-f-Messung ausgelegt. In der erfindungsgemäßen Untersuchungsvorrichtung können beide Messungen vereint werden und die Messergebnisse aus beiden Messungen als Eingangsgrößen für die Simulations- und Auswerteeinrichtung bereitgestellt werden. Durch die Kombination beider Messungen wird die Zuverlässigkeit der Erfassung der gesuchten Eigenschaften des organischen Materials deutlich erhöht.

Alternativ oder zusätzlich kann gemäß einer weiteren Variante der Erfindung vorgesehen sein, dass die elektrischen Messwerte in Abhängigkeit von der Probentemperatur erfasst werden. Beispielsweise werden die I-V- und/oder C-V-f-Kennlinien bei mindestens zwei Temperaturen gemessen. Die Messung erfolgt z. B. bei Raumtemperatur, die typischerweise auch die Betriebstemperatur des Bauelements ist, und bei einer in Bezug auf die Raumtemperatur erhöhten (z. B. bis +40 °C) oder erniedrigten Temperatur (z. B. bis -20 °C) gemessen. Vorteilhafterweise ermöglicht die Variation der Temperatur, die Genauigkeit der bestimmten Materialparameter zu erhöhen. Die Steuerung der Messeinrichtung in Abhängigkeit von der Steuerfunktion umfasst bei den dargestellten Messverfahren z. B. die Vorgabe einer bestimmten Messgeometrie und die Einstellung von einem Spannungsbereich und Temperaturwerten, für welche die I-V-Kennlinie aufgenommen werden soll. Vorteilhafterweise sind z. B. basierend auf numerischen Verfahren entwickelte Strom-Spannungs-Simulationsfunktionen und Impedanz-Simulationsfunktionen verfügbar, welche die gesuchten Eigenschaften des Materials enthalten und die nach der Messung an die Messwerte angepasst werden.

Alternativ oder zusätzlich kann gemäß einer weiteren Variante der Erfindung vorgesehen sein, dass die elektrischen Messwerte in Abhängigkeit von der Zeit in Form einer transienten Messung oder eines gepulsten Verfahrens gemessen werden. Vorteilhafterweise ermöglicht dies, dynamische elektrische Eigenschaften des organischen Materials auf verschiedenen Zeitskalen und/oder bei starken elektrischen Anregungen zu charakterisieren. In diesem Fall werden verfügbare Transienten-Simulationsfunktionen verwendet, welche zeitabhängige Eigenschaften des Materials enthalten und die nach der Messung an die Messwerte angepasst werden.

Gemäß einer weiteren vorteilhaften Variante der Erfindung kann die Untersuchungsvorrichtung mit einer Konsistenztesteinrichtung ausgestattet sein. Bei dieser Ausführungsform der Erfindung werden die Materialeigenschaften aus der angepassten Simulationsfunktion einem Konsistenztest unterzogen. Die Konsistenz der ermittelten Materialeigenschaften wird z. B. anhand von Fehlertoleranzen, die sich aus der Simulation ergeben, oder durch Vergleich mit anderen Materialeigenschaften oder mit Materialeigenschaften anderer Proben überprüft. Vorteilhafterweise ermöglicht die Erfindung einen automatisierten Konsistenztest.

Weitere Einzelheiten und Vorteile der Erfindung werden aus der folgenden Beschreibung bevorzugter Ausführungsformen der Erfindung anhand der beigefügten Zeichnungen ersichtlich. Es zeigen:
- Figur 1:: eine schematische Darstellung einer Ausführungsform der erfindungsgemäßen Untersuchungsvorrichtung; und
- Figur 2:: eine schematische Blockdarstellung mit Merkmalen von Ausführungsformen des erfindungsgemäßen Untersuchungsverfahrens.

Ausführungsformen der Erfindung werden im Folgenden unter beispielhaftem Bezug auf die Steuerung der elektrischen Messung und/oder der Simulation, die Filterung der Messergebnisse und den Konsistenztest der Simulationsergebnisse beschrieben, welche wichtige Merkmale der vorliegenden Erfindung darstellen. Einzelheiten der untersuchten Materialien, der Durchführung der elektrischen Messung, der Datenverarbeitung oder der Gestalt der Simulationsfunktionen werden nicht beschrieben, soweit diese an sich von den herkömmlichen Techniken bekannt sind.

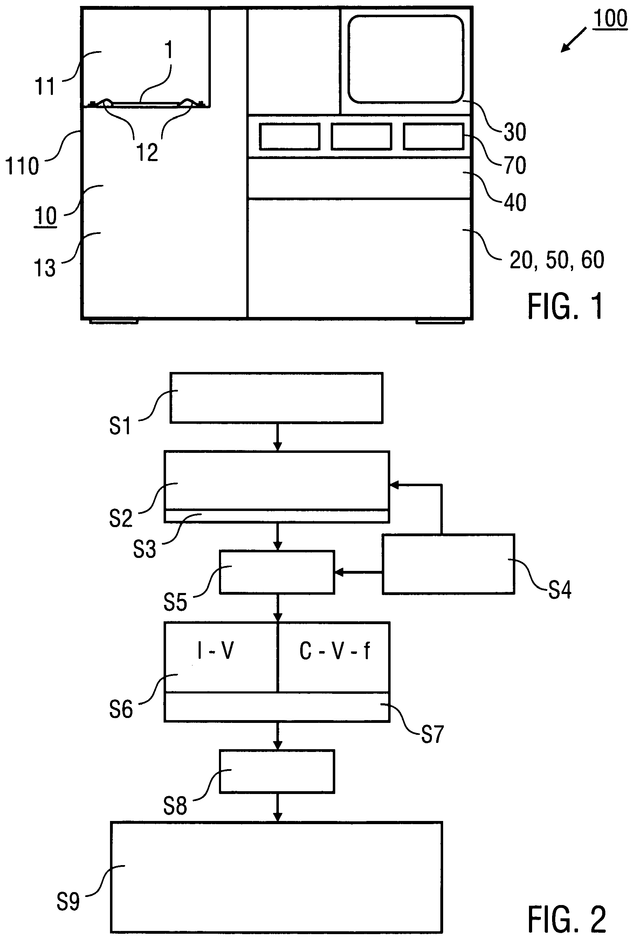

Figur 1 illustriert schematisch eine Ausführungsform einer erfindungsgemäßen Untersuchungsvorrichtung 100, bei der die Messeinrichtung 10, die Simulations- und Auswerteeinrichtung 20, die Ausgabeeinrichtung 30, die Steuereinrichtung 40, die Filtereinrichtung 50, die Konsistenztesteinrichtung 60 und eine Eingabeeinrichtung 70 in einem gemeinsamen Gehäuse 110 angeordnet sind. Bei der dargestellten Ausführungsform bildet die Untersuchungsvorrichtung 100 ein kompaktes Gerät, das z. B. für den Laboreinsatz oder für den Einsatz bei der Produktion elektronischer Bauelemente ausgelegt ist. Es ist nicht zwingend erforderlich, dass alle Komponenten 10 bis 70 ein einheitliches Gerät bilden. Alternativ kann es, insbesondere bei der Anwendung im Produktionsprozess, vorteilhaft sein, wenn z. B. die Messeinrichtung 10 von den Komponenten 20 bis 70 örtlich getrennt angeordnet und betrieben wird. Es können insbesondere mehrere Messeinrichtungen mit einer zentralen Datenverarbeitungseinrichtung, umfassend die Komponenten 20 bis 70, verbunden sein.

Die Messeinrichtung 10 umfasst eine Probenaufnahme 11, die zur Positionierung und ggf. Temperierung von mindestens einer Probe 1 konfiguriert ist. Obwohl in Figur 1 nur eine Probe 1 gezeigt ist, erfolgt die Messung in der Praxis vorzugsweise an mehreren Proben. Die Probenaufnahme 11 kann beispielsweise eingerichtet sein, zwei, drei, vier oder mehr Proben aufzunehmen. Dies ist von Vorteil, um mehrere I-V-Messungen für unterschiedliche Schichtdicken für eine Parameterbestimmung durchzuführen. Der Probenaufbau umfasst z. B. übereinander angeordnet ein Substrat, einen ersten Kontakt auf dem Substrat, organische Schichten, und einen Endkontakt auf den organischen Schichten. Die organischen Schichten umfassen z. B. eine erste Schicht mit bekannten Eigenschaften, eine zweite Schicht mit unbekannten Eigenschaften, die erfasst werden sollen, und eine dritte Schicht mit bekannten Eigenschaften. Der erste Kontakt und der Endkontakt sind in einer Richtung senkrecht zur Substratfläche übereinander angeordnet. Der Stromfluss während der Messung ist in erster Näherung senkrecht zum Substrat, so dass sich die erfindungsgemäß ermittelten Materialparameter ebenfalls auf diese Orientierung beziehen. Die Temperierung erfolgt z. B. mit einem geregelten Peltierelement.

Die Bauelement-Probe 1 enthält z. B. eine Schicht des zu untersuchenden Materials auf einem Substrat, wie z. B. eine organische Schicht aus N,N'-bis(1-naphthyl)-N,N'-diphenyl-1,1'-biphenyl-4,4'-diamin (NPB) auf Indium-Zinn-Oxid (ITO) auf einem Glas- oder Kunststoff-Substrat. In der Probenaufnahme 11 sind elektrische Kontakte 12 vorgesehen, über welche die mindestens eine Probe 1 mit einer Messeinheit 13 der Messeinrichtung 10 verbunden wird. Wenn mehrere Proben vorgesehen sind, werden diese typischerweise in der Probenaufnahme 11 gleichzeitig kontaktiert, aber aufeinander folgend vermessen. Bei mehreren Messkanälen kann die Messung auch parallel erfolgen, wenn für eine ausreichende Entkopplung gesorgt ist. Die Messeinheit 13 ist ein kommerziell verfügbares Messgerät, das in Abhängigkeit von den Aufgaben der Untersuchungsvorrichtung 100 z. B. mit einer I-V-Karte und einer C-V-f-Karte ausgestattet ist. Vorzugsweise enthält die Messeinheit 13 sowohl eine I-V- als auch eine C-V-f-Karte, so dass erfindungsgemäß beide Messungen vereint werden und die Messergebnisse aus beiden Messungen als Eingangsgrößen für die Simulationsund Auswerteeinrichtung bereitgestellt werden können.

Die Messeinrichtung 10 ist mit einer Recheneinheit verbunden, welche die Simulations- und Auswerteeinrichtung 20, die Filtereinrichtung 50 und die Konsistenztesteinrichtung 60 bereitstellt. Des Weiteren ist die Steuereinrichtung 40 mit der Messeinrichtung 10 und der Simulations- und Auswerteeinrichtung 50 verbunden. In der Steuereinrichtung 40, die ebenfalls Teil der Recheneinheit sein kann, ist mindestens eine Steuerfunktion gespeichert, die zur Einstellung der Messeinrichtung 10 und der Simulations- und Auswerteeinrichtung 20 ausgelegt ist. Die Steuerfunktion umfasst z. B. eine Befehlsfolge mit einer Definition des Spannungsbereiches, in dem mit der Messeinrichtung 10 eine I-V-Kennlinie der mindestens einen Probe 1 gemessen werden soll. Es können auch Einzelheiten des Spannungsbereiches vorgegeben werden, wie z. B. die Anzahl von Messungen und die Messung bei bestimmten Spannungswerten oder an bestimmten elektrischen Kontakten der mindestens einen Probe 1.

Optional kann vorgesehen sein, dass die Steuerfunktion vom Anwender in Abhängigkeit von den konkreten Anwendungsbedingungen variiert wird. Hierzu ist die Eingabeeinrichtung 70 vorgesehen, die verschiedene Schnittstellen 71 zur Eingabe und Speicherung der Steuerfunktion und/oder zur Veränderung der gespeicherten Steuerfunktion enthält. Die Eingabeeinrichtung 70 kann des Weiteren zur manuellen Bedienung der Messeinrichtung 10 und zur Bedienung der Komponenten 20, 50, 60 und 30 verwendet werden.

Die Ausgabeeinrichtung 30 ist in Figur 1 schematisch als gesonderte Komponente gezeigt, kann aber auch in die Recheneinheit mit den Komponenten 20, 50 und 60 integriert sein. Die Ausgabeeinrichtung 30 ist für eine Ausgabe der gesuchten Eigenschaften der Probe 1 mit an sich verfügbaren Mitteln, wie z. B. den Ausdruck auf einem Druckmedium, die Speicherung auf einem Speichermedium oder die Anzeige auf einem Display 31 ausgelegt.

Die Untersuchungsvorrichtung 100 wird z. B. mit dem in Figur 2 schematisch gezeigten Untersuchungsverfahren gemäß der Erfindung betrieben. Zunächst erfolgt bei Schritt S1 eine Kontaktierung der Probe. Zur Probenkontaktierung kann jedes an sich kommerziell verfügbare Verfahren zur elektrischen Kontaktierung organischer oder anorganischer Proben verwendet werden, wie z. B. über Kontaktfederstifte.

Anschließend erfolgt bei Schritt S2 die Messung an der Probe, wie z. B. eine I-V- und/oder eine C-V-f-Messung. Optional kann die Messung mit einem Schritt S3 gekoppelt sein, der eine Temperierung der Probe umfasst. Es können beispielsweise I-V- und/oder C-V-f-Messungen in Abhängigkeit von der Temperatur oder einzelne Datenpunkte der genannten Messungen bei verschiedenen Temperaturen aufgenommen werden.

Die elektrische Messung (Schritt S2) und die optionale Temperierung (Schritt S3) werden durch die gespeicherte Steuerfunktion gesteuert (Schritt S4). Die Steuerfunktion wird auch als "Rezept" bezeichnet. Sie enthält Vorschriften, welche Probe mit welcher Messung und welchen Messparametern gemessen wird.

Bei Schritt S5 werden aus den Messwerten die Daten herausgefiltert, die für die anschließende Simulation bei Schritt S6 verwendet werden sollen. Schritt S5 umfasst z. B. die Anwendung von Algorithmen zur Erkennung von Kriechströmen oder unerwünschten parasitären Effekten. Auch die Filterung bei Schritt S5 wird mit der Steuerung in Schritt S4 in Abhängigkeit von der aktuell untersuchten Probe eingestellt.

Die Messung und Filterung liefert z. B. fünf Strom- und Spannungspunkte einer I-V-Kennlinie, die bei Schritt S6 einer Simulation unterzogen wird. Hierzu wird z. B. die kommerziell verfügbare Software "SimOLED FITTING" verwendet. Bei Kombination der I-V- und C-V-f-Messungen können vorteilhafterweise unerwünschte Nebenlösungen im Simulationsergebnis ausgeschlossen werden. Wenn beispielsweise allein eine I-V-Simulationsfunktion angewendet wird, kann es zu drei Modellparametersätzen führen, von denen nur ein Modellparametersatz die realen Eigenschaften der untersuchten Probe widerspiegelt. Die Auswahl des richtigen Modellparametersatzes kann unter Anwendung der C-V-f-Simulationsfunktion erfolgen. Vorteilhafterweise wird mit der Kombination der I-V- und C-V-f-Simulationen der Raum der möglichen Simulationsergebnisse eingeschränkt und damit Zuverlässigkeit des Simulationsergebnisses verbessert.

Bei der C-V-f-Simulation wird die Kapazität der organischen Schicht als Funktion der Spannung und der Frequenz ermittelt. Diese Simulation ist eine Grundlage für ein anschließendes C-V-f-Fitting zur Bestimmung der gesuchten Eigenschaften der Probe aus der Kombination der I-V- und C-V-f-Messungen. Dabei wird wiederum an sich bekannte Software angewendet. Bei Schritt S7 erfolgt die Anpassung der Simulationsfunktion an die gemessenen Datenpunkte.

Nach der Anpassung bei Schritt S7 werden die Materialeigenschaften ausgegeben, die anschließend bei Schritt S8 einem Konsistenztest unterzogen werden. Die gefundenen Materialeigenschaften werden auf physikalische Konsistenz überprüft. Bei Bedarf werden inkonsistente Ergebnisse verworfen und/oder eine Wiederholung der Schritte S2 bis S7 gestartet.

Schließlich folgt bei Schritt S9 die Ausgabe der erfassten Materialeigenschaften, die sich z. B. auf die Energieniveaus, die Ladungsträgerbeweglichkeiten und/oder Verunreinigungskonzentrationen in der untersuchten Probe beziehen.

Wenn die Eigenschaften von mehreren Materialien der Probe erfasst werden, wird das Verfahren mit den Schritten gemäß Figur 2 für jedes Material separat oder für Gruppen von Materialien, z. B. aneinandergrenzende Schichten, gemeinsam ausgeführt.

Die in der Beschreibung, den Zeichnungen und den Ansprüchen offenbarten Merkmale der Erfindung können sowohl einzeln als auch in Kombination für die Verwirklichung der Erfindung in ihre verschiedenen Ausgestaltungen von Bedeutung sein.

## Patentansprüche

1. Untersuchungsvorrichtung (100) zur Erfassung von Eigenschaften mindestens eines Materials, das in mindestens einer Bauelement-Probe (1) enthalten ist, umfassend:
- eine Messeinrichtung (10), mit der elektrische Messwerte an der Bauelement-Probe (1) erfassbar sind, und
- eine Simulations- und Auswerteeinrichtung (20), die zur Anpassung einer Simulationsfunktion, welche die Eigenschaften der Bauelement-Probe (1) als Parameter enthält, an die elektrischen Messwerte eingerichtet ist, wobei
- eine Ausgabeeinrichtung (30) vorgesehen ist, die zur Ausgabe der Materialeigenschaften aus der angepassten Simulationsfunktion eingerichtet ist,
**gekennzeichnet durch**
- eine Steuereinrichtung (40), mit der mindestens eine der Messeinrichtung (10) und der Simulations- und Auswerteeinrichtung (20) in Abhängigkeit von einer gespeicherten, probenspezifischen Steuerfunktion steuerbar ist und wobei die Ausgabeeinrichtung (30) eingerichtet ist, als Materialeigenschaften Energieniveaus, Ladungsträgerbeweglichkeiten und/oder elektrisch wirksame Fallenzustände, insbesondere Verunreinigungen, Störstellen und/oder Defekte, auszugeben.

2. Untersuchungsvorrichtung gemäß Anspruch 1, bei der die Steuereinrichtung (40) mindestens eines der Merkmale umfasst:
- die Steuereinrichtung (40) ist eingerichtet, elektrische Messbereiche und/oder geometrische Messbedingungen und/oder Umgebungsbedingungen an der Messeinrichtung (10) einzustellen,
- die Steuereinrichtung (40) ist für eine benutzerdefinierte Veränderung der Steuerfunktion eingerichtet, und
- die Steuereinrichtung (40) ist eingerichtet, die Simulationseinrichtung (20) in Abhängigkeit von der Steuerfunktion zu steuern.

3. Untersuchungsvorrichtung gemäß einem der vorhergehenden Ansprüche, die umfasst:
- eine Filtereinrichtung (50), mit der aus mindestens einem Datensatz der elektrischen Messwerte eine Gruppe von Nutzdaten zur Eingabe an die Simulationseinrichtung (20) auswählbar ist.

4. Untersuchungsvorrichtung gemäß Anspruch 3, bei der
- die Filtereinrichtung (50) mit der Steuereinrichtung (40) in Abhängigkeit von der gespeicherten, probenspezifischen Steuerfunktion steuerbar ist.

5. Untersuchungsvorrichtung gemäß Anspruch 3 oder 4, bei der
- die Filtereinrichtung (50) eingerichtet ist, aus dem mindestens einen Datensatz der elektrischen Messwerte fehlerhafte Messwerte auszufiltern und/oder den Datensatz einer modell-basierten Anpassung zur Gewinnung der Nutzdaten zu unterziehen und/oder eine optimierte Anzahl der Nutzdaten einzustellen und/oder die Nutzdaten einer Wichtung zu unterziehen.

6. Untersuchungsvorrichtung gemäß einem der vorhergehenden Ansprüche, bei der
- die Messeinrichtung (10) eingerichtet ist, als Messwerte Stromwerte in Abhängigkeit von einer an die Bauelement-Probe (1) angelegten Spannung und/oder Impedanzwerte in Abhängigkeit von einer an die Bauelement-Probe (1) angelegten Spannung und deren Frequenz zu erfassen,
- die Messeinrichtung (10) eingerichtet ist, die Messwerte in Abhängigkeit von der Temperatur der Bauelement-Probe (1) zu erfassen, und/oder
- die Messeinrichtung (10) eingerichtet ist, die Messwerte in Abhängigkeit von der Zeit zu erfassen.

7. Untersuchungsvorrichtung gemäß Anspruch 6, bei der
- die Simulations- und Auswerteeinrichtung (20) zur Anpassung einer Strom-Spannungs-Simulationsfunktion, einer Impedanz-Simulationsfunktion und/oder einer Transienten-Simulationsfunktion an die elektrischen Messwerte eingerichtet ist.

8. Untersuchungsvorrichtung gemäß einem der vorhergehenden Ansprüche, die umfasst:
- eine Konsistenztesteinrichtung (60), die eingerichtet ist, die Eigenschaften der Bauelement-Probe (1) aus der angepassten Simulationsfunktion einem Konsistenztest zu unterziehen.

9. Verfahren zur Erfassung von Eigenschaften mindestens eines Materials, das in mindestens einer Bauelement-Probe (1) enthalten ist, mit den Schritten:
- Erfassung elektrischer Messwerte an der mindestens einen Bauelement-Probe (1),
- Anpassung einer Simulationsfunktion, welche die Eigenschaften der mindestens einen Bauelement-Probe (1) als Parameter enthält, an die elektrischen Messwerte, und
- Ausgabe der Eigenschaften der mindestens einen Bauelement-Probe (1) aus der angepassten Simulationsfunktion, **gekennzeichnet durch** den Schritt
- Steuerung von mindestens einem der Schritte Erfassung der elektrischen Messwerte und Anpassung der Simulationsfunktion in Abhängigkeit von einer gespeichert, probenspezifischen Steuerfunktion und wobei die Ausgabe der Eigenschaften der mindestens einen Bauelement-Probe (1) die Ausgabe von Energieniveaus, Ladungsträgerbeweglichkeiten und elektrisch wirksame Fallenzustände, insbesondere Verunreinigungen, Störstellen und/oder Defekte, umfasst.

10. Verfahren gemäß Anspruch 9, bei dem
- die Steuerung der Erfassung der elektrischen Messwerte eine Einstellung elektrischer Messbereiche und/oder geometrischer Messbedingungen und/oder Umgebungsbedingungen umfasst.

11. Verfahren gemäß einem der Ansprüche 9 bis 10, mit dem Schritt:
- Auswahl einer Gruppe von Nutzdaten aus mindestens einem Datensatz der elektrischen Messwerte.

12. Verfahren gemäß Anspruch 11, mit dem Schritt
- Steuerung der Auswahl der Gruppe von Nutzdaten in Abhängigkeit von der gespeicherten, probenspezifischen Steuerfunktion.

13. Verfahren gemäß Anspruch 11 oder 12, bei dem die Auswahl der Gruppe von Nutzdaten mindestens einen der Schritte umfasst:
- Ausfiltern und/oder modell-basierte Anpassung des Datensatzes zur Gewinnung der Nutzdaten,
- Einstellung einer optimierten Anzahl der Nutzdaten, und
- Wichtung der Nutzdaten.

14. Verfahren gemäß einem der Ansprüche 9 bis 13, bei dem die Erfassung der elektrischen Messwerte mindestens einen der Schritte ausführt:
- Erfassung von Stromwerten in Abhängigkeit von einer an die mindestens eine Bauelement-Probe (1) angelegten Spannung, und
- Erfassung von Impedanzwerten in Abhängigkeit von einer an die mindestens eine Bauelement-Probe (1) angelegten Spannung und deren Frequenz,
- Erfassung der elektrischen Messwerte in Abhängigkeit von der Zeit, und
- Kontrolle der Umgebungsbedingungen.

15. Verfahren gemäß Anspruch 14, mit dem Schritt
- Anpassung einer Strom-Spannungs-Simulationsfunktion, einer Impedanz-Simulationsfunktion und/oder einer Transienten-Simulationsfunktion an die elektrischen Messwerte.

16. Verfahren gemäß einem der Ansprüche 9 bis 15, mit dem Schritt
- Konsistenztest der Eigenschaften der mindestens einen Bauelement-Probe (1) aus der angepassten Simulationsfunktion.

17. Verfahren gemäß einem der Ansprüche 9 bis 16, bei dem die mindestens eine Bauelement-Probe (1) mindestens eines umfasst von
- mindestens einer organischen Feststoffschicht, insbesondere einer organischen Schicht zur Anwendung in einem organischen Halbleiterbauelement, insbesondere in einer organischen Leuchtdiode, einem organischen Transistor und/oder einer organischen Solarzelle,
- mindestens einer anorganischen Feststoffschicht, insbesondere einer Metall- oder Oxidschicht, und
- mindestens einer zusammengesetzten Schicht, die organische und anorganische Bestandteile umfasst.

18. Verfahren gemäß einem der Ansprüche 9 bis 17, bei dem
- die mindestens eine Bauelement-Probe (1) ein organisches Halbleiterbauelement, insbesondere eine organische Leuchtdiode, einen organischen Transistor oder eine organische Solarzelle, oder ein Teil von diesem umfasst.

## Claims

1. Inspection device (100) for detecting properties of at least one material which is contained in at least one component sample (1), comprising:
- a measuring means (10) with which measured electrical values can be acquired on the component sample (1), and
- a simulation and evaluation means (20) which is designed to adapt a simulation function, which contains the properties of the component sample (1) as parameters, to the measured electrical values,
- an output means (30) being provided which is designed to output the material properties from the adapted simulation function,
**characterised by**
- a control means (40) with which at least one of the measuring means (10) and the simulation and evaluation means (20) can be controlled on the basis of a stored, sample-specific control function, and the output means (30) being designed to output, as material properties, energy levels, charge carrier mobilities and electrically effective trap states, in particular impurities, interference points and/or defects.

2. Inspection device according to claim 1, wherein the control means (40) comprises at least one of the following features:
- the control means (40) is designed to set electrical measuring ranges and/or geometric measuring conditions and/or ambient conditions on the measuring means (10),
- the control means (40) is designed for a user-defined change to the control function, and
- the control means (40) is designed to control the simulation means (20) on the basis of the control function.

3. Inspection device according to either of the preceding claims, comprising:
- a filter means (50) with which a group of useful data items can be selected from at least one data set of the measured electrical values for input to the simulation means (20).

4. Inspection device according to claim 3, wherein
- the filter means (50) can be controlled using the control means (40) on the basis of the stored, sample-specific control function.

5. Inspection device according to either claim 3 or claim 4, wherein
- the filter means (50) is designed to filter out incorrect measured values from the at least one data set of the measured electrical values and/or to subject the data set to a model-based adaptation to obtain the useful data items and/or to set an optimised number of useful data items and/or to subject the useful data items to weighting.

6. Inspection device according to any of the preceding claims, wherein
- the measuring means (10) is designed to acquire, as measured values, current values as a function of a voltage applied to the component sample (1) and/or impedance values as a function of a voltage applied to the component sample (1) and its frequency,
- the measuring means (10) is designed to acquire the measured values as a function of the temperature of the component sample (1), and/or
- the measuring means (10) is designed to acquire the measured values as a function of time.

7. Inspection device according to claim 6, wherein
- the simulation and evaluation means (20) is designed to adapt a current-voltage simulation function, an impedance simulation function and/or a transient simulation function to the measured electrical values.

8. Inspection device according to any of the preceding claims, comprising:
- a consistency test means (60) which is designed to subject the properties of the component sample (1) from the adapted simulation function to a consistency test.

9. Method for detecting properties of at least one material which is contained in at least one component sample (1), comprising the following steps:
- acquiring measured electrical values on the at least one component sample (1),
- adapting a simulation function, which contains the properties of the at least one component sample (1) as parameters, to the measured electrical values, and
- outputting the properties of the at least one component sample (1) from the adapted simulation function,
**characterised by** the step of
- controlling at least one of the steps of acquiring the measured electrical values and adapting the simulation function on the basis of a stored, sample-specific control function, and the output of the properties of the at least one component sample (1) involving the output of energy levels, charge carrier mobilities and electrically effective trap states, in particular, impurities, interference points and/or defects.

10. Method according to claim 9, wherein
- the control of the acquisition of the measured electrical values involves setting electrical measuring ranges and/or geometric measuring conditions and/or ambient conditions.

11. Method according to either claim 9 or claim 10, comprising the step of:
- selecting a group of useful data items from at least one data set of the measured electrical values.

12. Method according to claim 11, comprising the step of
- controlling the selection of the group of user data items on the basis of the stored, sample-specific control function.

13. Method according to either claim 11 or claim 12, wherein the selection of the group of user data items comprises at least one of the following steps:
- filtering out and/or model-based adaptation of the data set to obtain the useful data items,
- setting an optimised number of user data items, and
- weighting the user data items.

14. Method according to any of claims 9 to 13, wherein the acquisition of the measured electrical values involves at least one of the following steps:
- acquiring current values as a function of a voltage applied to the at least one component sample (1), and
- acquiring impedance values as a function of a voltage applied to the at least one component sample (1) and its frequency,
- acquiring the measured electrical values as a function of time, and
- monitoring the ambient conditions.

15. Method according to claim 14, comprising the step of
- adapting a current-voltage simulation function, an impedance simulation function and/or a transient simulation function to the measured electrical values.

16. Method according to any of claims 9 to 15, comprising the step of
- a consistency test of the properties of the at least one component sample (1) from the adapted simulation function.

17. Method according to any of claims 9 to 16, wherein the at least one component sample (1) comprises at least one of
- at least one organic solid layer, in particular an organic layer for use in an organic semiconductor component, in particular in an organic light-emitting diode, an organic transistor and/or an organic solar cell,
- at least one inorganic solid layer, in particular a metal or oxide layer, and
- at least one composite layer comprising organic and inorganic constituents.

18. Method according to any of claims 9 to 17, wherein
- the at least one component sample (1) comprises an organic semiconductor component, in particular an organic light-emitting diode, an organic transistor or an organic solar cell, or a part thereof.

## Revendications

1. Dispositif d'analyse (100) permettant de déterminer des propriétés d'au moins un matériau contenu dans au moins un échantillon d'élément structural (1), comprenant:
- un système de mesure (10) avec lequel des valeurs mesurées électriques peuvent être acquises dans l'échantillon d'élément structural (1), et
- un système de simulation et d'évaluation (20), lequel est configuré pour adapter aux valeurs mesurées électriques une fonction de simulation contenant les propriétés de l'échantillon d'élément structural (1) en tant que paramètres,
- un système de sortie (30) étant prévu, lequel est configuré pour délivrer en sortie les propriétés du matériau à partir de la fonction de simulation adaptée,
**caractérisé par**
- un système de commande (40) avec lequel au moins l'un du système de mesure (10) et du système de simulation et d'évaluation (20) peut être commandé en fonction d'une fonction de commande stockée spécifique à l'échantillon, et le système de sortie (30) étant configuré pour délivrer en sortie, en tant que propriétés du matériau, des niveaux d'énergie, des mobilités de porteurs de charge et des états de piégeage électriquement efficaces, en particulier des impuretés, des imperfections et/ou des défauts.

2. Dispositif d'analyse selon la revendication 1, dans lequel le système de commande (40) comprend au moins l'une des caractéristiques suivantes :
- le système de commande (40) est configuré pour régler des plages de mesure électriques et/ou des conditions de mesure géométriques et/ou des conditions ambiantes dans le système de mesure (10),
- le système de commande (40) est configuré pour un changement défini par l'utilisateur de la fonction de commande, et
- le système de commande (40) est configuré pour commander le système de simulation (20) en fonction de la fonction de commande.

3. Dispositif d'analyse selon l'une des revendications précédentes, comprenant:
- un système de filtrage (50) avec lequel un groupe de données utiles destinées à être entrées dans le système de simulation (20) peut être sélectionné à partir d'au moins un ensemble de données des valeurs mesurées électriques.

4. Dispositif d'analyse selon la revendication 3, dans lequel
- le système de filtrage (50) peut être commandé par le système de commande (40) en fonction de la fonction de commande stockée spécifique à l'échantillon.

5. Dispositif d'analyse selon la revendication 3 ou 4, dans lequel
- le système de filtrage (50) est configuré pour filtrer les valeurs mesurées incorrectes de l'au moins un ensemble de données des valeurs mesurées électriques et/ou pour soumettre l'ensemble de données à une adaptation basée sur un modèle pour obtenir les données utiles et/ou pour régler un nombre optimisé de données utiles et/ou pour soumettre les données utiles à une pondération.

6. Dispositif d'analyse selon l'une des revendications précédentes, dans lequel
- le système de mesure (10) est configuré pour acquérir, en tant que valeurs mesurées, des valeurs de courant en fonction d'une tension appliquée à l'échantillon d'élément structural (1) et/ou des valeurs d'impédance en fonction d'une tension appliquée à l'échantillon d'élément structural (1) et de sa fréquence,
- le système de mesure (10) est configuré pour acquérir les valeurs mesurées en fonction de la température de l'échantillon d'élément structural (1), et/ou
- le système de mesure (10) est configuré pour acquérir les valeurs mesurées en fonction du temps.

7. Dispositif d'analyse selon la revendication 6, dans lequel
- le système de simulation et d'évaluation (20) est configuré pour adapter une fonction de simulation de courant-tension, une fonction de simulation d'impédance et/ou une fonction de simulation transitoire aux valeurs mesurées électriques.

8. Dispositif d'analyse selon l'une des revendications précédentes, comprenant :
- un système de test de consistance (60) qui est configuré pour soumettre à un test de consistance les propriétés de l'échantillon d'élément structural (1) provenant de la fonction de simulation adaptée.

9. Procédé permettant de déterminer des propriétés d'au moins un matériau contenu dans au moins un échantillon d'élément structural (1), comprenant les étapes :
- d'acquisition de valeurs mesurées électriques dans l'au moins un échantillon d'élément structural (1),
- d'adaptation, aux valeurs mesurées électriques, d'une fonction de simulation contenant les propriétés de l'au moins un échantillon d'élément structural (1) en tant que paramètres, et
- de sortie des propriétés de l'au moins un échantillon d'élément structural (1) à partir de la fonction de simulation adaptée,
**caractérisé par** l'étape
- de commande d'au moins l'une des étapes d'acquisition des valeurs mesurées électriques et d'adaptation de la fonction de simulation en fonction d'une fonction de commande stockée spécifique à l'échantillon, la sortie des propriétés de l'au moins un échantillon d'élément structural (1) comprenant la sortie de niveaux d'énergie, de mobilités de porteurs de charge et d'états de piégeage électriquement efficaces, en particulier d'impuretés, d'imperfections et/ou de défauts.

10. Procédé selon la revendication 9, dans lequel
- la commande de l'acquisition des valeurs mesurées électriques comprend un réglage des plages de mesure électriques et/ou des conditions de mesure géométriques et/ou des conditions ambiantes.

11. Procédé selon l'une des revendications 9 à 10, comportant l'étape :
- de sélection d'un groupe de données utiles à partir d'au moins un ensemble de données des valeurs mesurées électriques.

12. Procédé selon la revendication 11, comportant l'étape :
- de commande de la sélection du groupe de données utiles en fonction de la fonction de commande stockée spécifique à l'échantillon.

13. Procédé selon la revendication 11 ou 12, dans lequel la sélection du groupe de données utiles comprend au moins l'une des étapes suivantes :
- filtrage et/ou adaptation, sur la base d'un modèle, de l'ensemble de données pour obtenir les données utiles,
- réglage d'un nombre optimisé de données utiles, et
- pondération des données utiles.

14. Procédé selon l'une des revendications 9 à 13, dans lequel l'acquisition des valeurs mesurées électriques effectue au moins l'une des étapes suivantes :
- acquisition de valeurs de courant en fonction d'une tension appliquée à l'au moins un échantillon d'élément structural (1), et
- acquisition de valeurs d'impédance en fonction d'une tension appliquée à l'au moins un échantillon d'élément structural (1) et de sa fréquence,
- acquisition des valeurs mesurées électriques en fonction du temps, et
- contrôle des conditions ambiantes.

15. Procédé selon la revendication 14, comportant l'étape :
- d'adaptation d'une fonction de simulation de courant-tension, d'une fonction de simulation d'impédance et/ou d'une fonction de simulation transitoire aux valeurs mesurées électriques.

16. Procédé selon l'une des revendications 9 à 15, comportant l'étape :
- de test de la consistance des propriétés de l'au moins un échantillon d'élément structural (1) à partir de la fonction de simulation adaptée.

17. Procédé selon l'une des revendications 9 à 16, dans lequel l'au moins un échantillon d'élément structural (1) comprend au moins l'un des éléments suivants :
- au moins une couche de matière solide organique, en particulier une couche organique à utiliser dans un élément structural semi-conducteur organique, en particulier dans une diode électroluminescente organique, un transistor organique et/ou une cellule solaire organique,
- au moins une couche de matière solide inorganique, en particulier une couche métallique ou une couche d'oxyde, et
- au moins une couche composite comprenant des composants organiques et inorganiques.

18. Procédé selon l'une des revendications 9 à 17, dans lequel
- l'au moins un échantillon d'élément structural (1) comprend un élément structural semi-conducteur organique, en particulier une diode électroluminescente organique, un transistor organique ou une cellule solaire organique, ou une partie de ceux-ci.
